# EUROPÄISCHE PATENTSCHRIFT

(11) **EP 1 569 365 B1**
(45) Veröffentlichungstag und Bekanntmachung des Hinweises auf die Patenterteilung: **26.03.2008**
(21) Anmeldenummer: 05090027.3
(22) Anmeldetag: 11.02.2005
(51) Int. Cl.: H04B 10/00, H01S 5/00

(54) **Optisches redundantes Sendemodul**
Redundant optical transmitting device
Dispositif d'émission optique redondant

(30) Priorität: 26.02.2004 US 788054
(43) Veröffentlichungstag der Anmeldung: 31.08.2005
(73) Patentinhaber: Avago Technologies Fiber IP (Singapore) Pte. Ltd., Singapore 768923 (SG)
(72) Erfinder: Schrödinger, Karl, 14089 Berlin (DE)
(74) Vertreter: Dilg, Haeusler, Schindelmann Patentanwaltsgesellschaft mbH

(56) Entgegenhaltungen:
- US-A- 4 281 416
- US-A- 4 403 139
- US-A1- 2003 011 851
- PATENT ABSTRACTS OF JAPAN Bd. 007, Nr. 292 (E-219), 27. Dezember 1983 (1983-12-27) & JP 58 168342 A (KOKUSAI DENSHIN DENWA KK), 4. Oktober 1983 (1983-10-04)

## Beschreibung

Die Erfindung bezieht sich auf ein optisches Sendemodul, insbesondere für optische Datenübertragungssysteme.

Optische Sendemodule sind aus den Druckschriften US2003/0011851, US-A-4 403 139 sowie US-A-4 281 416 bekannt.

Der Erfindung liegt die Aufgabe zugrunde, ein optisches Sendemodul anzugeben, das ein besonders hohes Maß an Ausfallsicherheit aufweist.

Die genannte Aufgabe wird erfindungsgemäß durch ein redundantes optisches Sendemodul mit zumindest zwei Sendeelementen und mit einer mit den zumindest zwei Sendeelementen in Verbindung stehenden Steuereinrichtung gelöst. Erfindungsgemäß schaltet die Steuereinrichtung im Sendebetrieb jeweils mindestens eines der Sendeelemente aktiv und zumindest eines der übrigen Sendeelemente passiv.

Ein wesentlicher Vorteil des erfindungsgemäßen optischen Sendemoduls besteht darin, dass dieses besonders ausfallsicher ist, da zumindest zwei Sendeelemente vorhanden sind, von denen zumindest eines ein "Ersatz-Sendeelement" bildet. Dies bedeutet, dass bei einem Ausfall des aktiven Sendeelements das Ersatz-Sendeelement anstelle des ausgefallenen Sendeelements in Betrieb genommen werden kann, so dass der Sendebetrieb aufrecht erhalten bleibt.

Vorzugsweise schaltet die Steuereinrichtung ein aktives Sendeelement jeweils ab und ersetzt dieses durch eines der übrigen zuvor passiven Sendeelemente, wenn das aktive Sendeelement defekt ist. Als defekt sieht die Steuereinrichtung ein aktives Sendeelement beispielsweise dann an, wenn dieses ein Betriebsverhalten zeigt, das außerhalb eines vorgegebenen Betriebsbereichs liegt.

Der Betriebsbereich der Sendeelemente ist vorzugsweise für jedes Sendeelement individuell - also sendeelementindividuell - vorgegeben.

Das Sendemodul kann beispielsweise eine Monitoreinrichtung aufweisen, die die optische Sendeleistung des mindestens einen aktiven Sendeelements misst und ein die jeweilige Sendeleistung angebendes Messsignal an die Steuereinrichtung überträgt. Die Steuereinrichtung ist in einem solchen Fall vorzugsweise derart ausgestaltet, dass sie das Betriebsverhalten der aktiven Sendeelemente unter Heranziehung des jeweils zugeordneten Messsignals der Monitoreinrichtung bestimmt.

Die Steuereinrichtung kann den Betriebsstrom für jedes der aktiven Sendeelemente beispielsweise vorgeben, indem sie auf eine vorgegebene Ansteuertabelle bzw. Look-up-Tabelle ("Look up table") zurückgreift. Die Steuereinrichtung schaltet in einem solchen Falle auf eines der übrigen Sendeelemente um, wenn die optische Sendeleistung eines der aktiven Sendeelemente eine vorgegebene optische Mindest-Sendeleistung unterschreitet.

Die Steuereinrichtung kann den Betriebsstrom dabei unter Berücksichtigung vorgegebener Betriebsparameter vorgeben, die in der bereits erwähnten Look-up-Tabelle enthalten sind. Beispielsweise kann als Betriebsparameter die Temperatur der Sendelemente berücksichtigt werden.

Alternativ kann die Steuereinrichtung die optische Sendeleistung der aktiven Sendeelemente durch Nachregeln des Betriebsstromes konstant halten, indem sie den Betriebsstrom unter Berücksichtigung der Messwerte der Monitoreinrichtung entsprechend einstellt: Ein Deaktivieren eines Sendeelements und ein Umschalten auf eines der übrigen Sendeelemente erfolgt vorzugsweise dann, wenn der zum Erreichen einer vorgegebenen optischen Sendeleistung erforderliche Betriebsstrom einen vorgegebenen Maximalstrom überschreitet oder überschreiten würde.

Vorzugsweise weist die Steuereinrichtung einen Speicher auf, in dem sie abspeichert, welche der Sendeelemente defekt sind und welche nicht. Wie bereits oben erwähnt, kann die Steuereinrichtung solche Sendeelemente als defekt auffassen, die zuvor ein Betriebsverhalten zeigten, das außerhalb eines vorgegebenen Betriebsbereichs lag, und die daher abgeschaltet wurden.

Der Speicher ist bevorzugt derart ausgestaltet, dass er die in ihm gespeicherten Speicherdaten auch während einer Abschaltphase des Sendemoduls gespeichert hält. Dies hat den Vorteil, dass nach einem erneuten Wiedereinschalten des optischen Sendemoduls nicht erneut geprüft werden muss, welche Sendeelemente defekt und welche betriebsbereit sind; denn die entsprechenden Informationen sind im Speicher abrufbar. Dementsprechend zieht die Steuereinrichtung während des Betriebs des Sendemoduls und/oder nach einem erneuten Wiedereinschalten des Sendemoduls lediglich diejenigen Sendeelemente für eine Aktivierung in Betracht, die in dem Speicher noch nicht als "defekt" abgespeichert sind.

Die Steuereinrichtung kann beispielsweise einen Kontroll-Baustein und eine mit dem Kontroll-Baustein in Verbindung stehende Schalteinrichtung aufweisen. Die Schalteinrichtung dient dann dazu, in Abhängigkeit von Steuersignalen des Kontroll-Bausteins diejenigen Sendeelemente einzuschalten, die aktiviert werden sollen.

Die Schalteinrichtung kann beispielsweise für jedes Sendeelement jeweils eine individuelle Treiberschaltung aufweisen, die mittels der Steuersignale des Kontroll-Bausteins aktivierbar oder abschaltbar ist.

Alternativ kann die Schalteinrichtung zumindest eine Treiberschaltung aufweisen, die ausgangsseitig zumindest zwei Sendeelementen zugeordnet ist. Zwischen der Treiberschaltung und den zugeordneten Sendeelementen werden vorzugsweise Schalter angeordnet, die mittels der Steuersignale des Kontroll-Bausteins ein- bzw. ausgeschaltet werden. Durch entsprechende Ansteuerung der Schalter können somit die zu aktivierenden Sendeelemente ausgewählt werden.

Um sicherzustellen, dass Personen bei der Benutzung des Sendemoduls nicht zu Schaden kommen können, weist die Steuereinrichtung vorzugsweise eine Lasersicherheitsschaltung zum Erkennen von unerlaubten Zuständen auf, mit der die Sendeelemente im Falle eines unerlaubten Zustandes bzw. eines Gefahrenzustandes deaktiviert werden.

Zur Übertragung von Fehlersignalen an ein mit dem Sendemodul in Verbindung stehendes externes System weist die Steuereinrichtung bevorzugt eine Fehlersignalausgangsschnittstelle zum Übertragen der Fehlersignale auf.

Darüber hinaus wird es als vorteilhaft angesehen, wenn die Steuereinrichtung ein Kommunikationsinterface aufweist, über das das Sendemodul mit anderen Sendemodulen Daten austauschen kann und darüber hinaus beispielsweise abgleichbar ist.

Vorzugsweise ist das Sendemodul derart ausgestaltet, dass es jeweils ein Sendeelement aktiv schaltet bzw. einschaltet und alle übrigen Sendeelemente abschaltet.
Die Erfindung bezieht sich außerdem auf ein Verfahren zum Betrieb eines Sendemoduls.

Diesbezüglich ist erfindungsgemäß vorgesehen, dass im Sendebetrieb des Sendemoduls jeweils mindestens eines der Sendeelemente des Sendemoduls aktiv geschaltet und zumindest eines der übrigen Sendeelemente des Sendemoduls passiv geschaltet wird.

Zur Erläuterung der Erfindung zeigen:
- Figur 1: ein erstes Ausführungsbeispiel für ein erfindungsgemäßes redundantes optisches Sendemodul,
- Figur 2: ein erstes Ausführungsbeispiel für eine Schalteinrichtung einer Steuereinrichtung des Sendemoduls gemäß Figur 1,
- Figur 3: ein zweites Ausführungsbeispiel für eine Schalteinrichtung der Steuereinrichtung gemäß Figur 1,
- Figur 4: ein Ausführungsbeispiel für einen Kontroll-Baustein der Steuereinrichtung des Sendemoduls gemäß Figur 1.

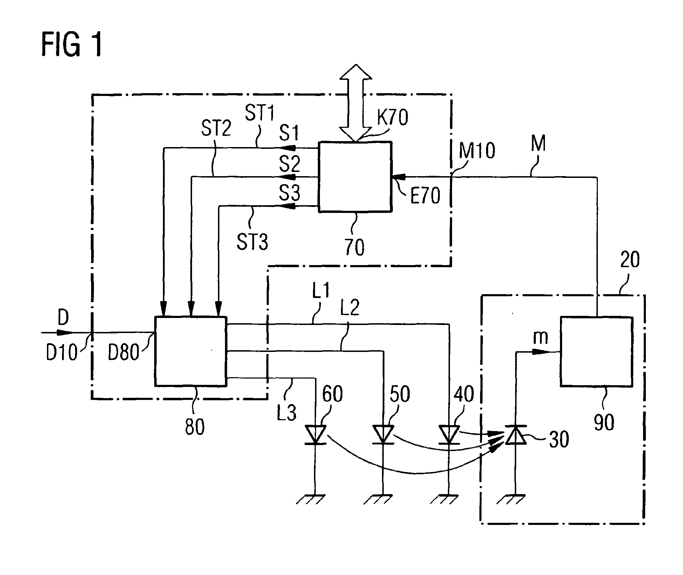

In der Figur 1 ist ein erstes Ausführungsbeispiel für ein redundantes optisches Sendemodul gezeigt. Das Sendemodul weist eine Steuereinrichtung 10 auf, die über einen Messeingang M10 mit einer Monitoreinrichtung 20 in Verbindung steht. Die Monitoreinrichtung 20 umfasst unter anderem ein Monitorelement 30, das optisch mit drei Sendeelementen 40, 50 und 60 gekoppelt ist. Die Sendeelemente 40, 50 und 60 können beispielsweise Laserdiode oder Lumineszenzdioden sein.

Die Steuereinrichtung 10 enthält einen Kontroll-Baustein 70, der mit seinem Eingang E70 mit dem Messeingang M10 der Steuereinrichtung 10 und damit mit der Monitoreinrichtung 20 verbunden ist. Ein Kommunikationsanschluss K70 des Kontroll-Bausteins 70 bildet ein Kommunikationsinterface K10 der Steuereinrichtung 10.

Der Kontroll-Baustein 70 ist ausgangsseitig über drei Steuerleitungen ST1, ST2 und ST3 mit einer Schalteinrichtung 80 verbunden.

Die Schalteinrichtung 80 weist einen Dateneingang D80 auf, der einen Dateneingang D10 der Steuereinrichtung 10 bildet. Über den Dateneingang D10 bzw. den Dateneingang D80 können Datensignale D in die Schalteinrichtung 80 eingespeist und von dort zu den drei Sendeelementen 40, 50 und 60 über Ansteuerleitungen L1, L2 und L3 übertragen werden.

Das Sendemodul gemäß Figur 1 wird wie folgt betrieben:

Bei einem erstmaligen neu Inbetriebnehmen des Sendemoduls wird der Kontroll-Baustein 70 zunächst eines der drei Sendeelemente 40, 50, bzw. 60 für den Sendebetrieb auswählen. Beispielsweise wählt der Kontroll-Baustein 70 das Sendeelement 40 als "erstes" Sendeelement aus.

Dementsprechend überträgt der Kontroll-Baustein 70 über die Steuerleitung ST1 ein entsprechendes Steuersignal S1 an die Schalteinrichtung 80, die daraufhin die am Dateneingang D10 bzw. D80 anliegenden Datensignale D, die mit dem Sendemodul gemäß Figur 1 übertragen werden sollen, über die Ansteuerleitung L1 zum Sendeelement 40 durchschaltet. Das Durchschalten der Datensignale kann beispielsweise erfolgen, in dem ein als das Steuersignal S1 von dem Kontroll-Baustein 70 gelieferter Betriebsstrom mit den Datensignalen D moduliert wird. Das Sendeelement 40 wird somit beginnen, die eingangsseitig anliegenden Daten D als optische Signale abzustrahlen.

Ein Teil des von dem Sendeelement 40 generierten Lichts wird von dem Monitorelement 30 der Monitoreinrichtung 20 empfangen, woraufhin das Monitorelement 30 einen entsprechenden Messstrom m erzeugt und zu einem Monitorverstärker 90 der Monitoreinrichtung 20 überträgt. Der Monitorverstärker 90 verstärkt den Messstrom m und bildet daraus ein verstärktes Messsignal M, das zum Messeingang M10 der Steuereinrichtung 10 und damit zum Eingang E70 des Kontroll-Bausteins 70 gelangt. Der Kontroll-Baustein 70 kann somit die optische Ausgangsleistung des Sendeelements 40 überwachen.

Stellt der Kontroll-Baustein 70 fest, dass die von dem Sendeelement 40 erzeugte optische Ausgangsleistung zu gering ist oder aber dass der zum Erreichen der vorgegebenen optischen Mindest-Sendeleistung erforderliche Betriebsstrom zu groß ist, so leitet der Kontroll-Baustein 70 daraus ab, dass das Sendelement 40 defekt ist. In einem solchen Fall wird der Kontroll-Baustein 70 das Sendeelement 40 abschalten und durch eines der beiden übrigen Sendeelemente 50 bzw. 60 ersetzen. Beispielsweise wird das Sendeelement 50 anstelle des Sendeelements 40 aktiviert. Eine solche Aktivierung erfolgt in der Weise, dass der Kontroll-Baustein 70 über die Steuerleitung ST2, die Schalteinrichtung 80 und die Ansteuerleitung L2 das Sendeelement 50 einschaltet.

In entsprechender Weise wird das dritte Sendelement 60 aktiviert, wenn das zweite Sendelement 50 ausgefallen ist.

Vorzugsweise weist der Kontroll-Baustein 70 einen Speicher auf, in dem er abspeichert, welche der drei Sendelemente 40, 50 und 60 defekt und welche betriebsbereit sind. Wird das Sendemodul nämlich zwischenzeitlich ausgeschaltet und anschließend erneut in Betrieb genommen, so kann der Kontroll-Baustein 70 durch Abfragen seines Speichers feststellen, welche der Sendelemente 40, 50 oder 60 für eine Inbetriebnahme nicht mehr infrage kommen, da diese defekt sind.

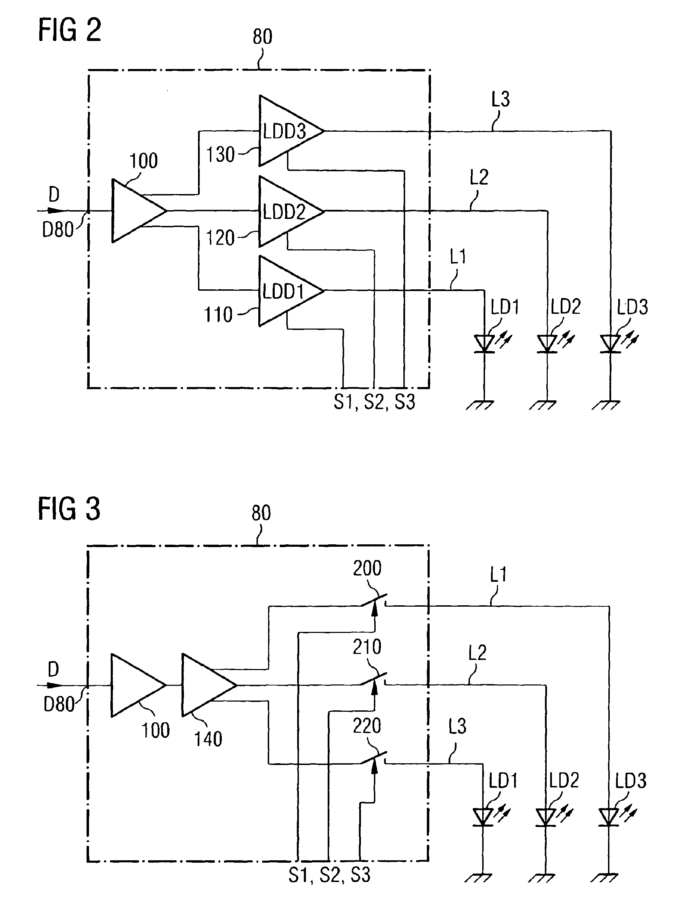

In der Figur 2 ist ein erstes Ausführungsbeispiel für die Schalteinrichtung 80 gemäß Figur 1 dargestellt. Man erkennt einen Eingangsverstärker 100, dessen Eingang den Dateneingang D80 der Schalteinrichtung 80 bildet. Ausgangsseitig ist der Eingangsverstärker 100 mit drei ein- und ausschaltbaren Lasertreiberschaltungen - nachfolgend kurz Lasertreiber genannt - 110, 120 und 130 verbunden.

Die drei Lasertreiber werden über Steuersignale S1, S2 und S3, die über die Steuerleitungen ST1, ST2 und ST3 von dem Kontroll-Baustein 70 übertragen werden, ein- oder ausgeschaltet. Mit den Steuersignalen S1, S2 und S3 können somit die drei Sendeelemente 40, 50 und 60 einzeln ausgewählt und eingeschaltet werden. Beispielsweise wird jeweils nur ein einziges Sendeelement aktiviert, und die übrigen Sendeelemente werden abgeschaltet. Alternativ können auch zwei der drei Sendeelemente aktiviert werden, wobei bei Ausfall eines der aktiven Sendelemente dieses durch das dritte, zuvor passive Sendeelement ersetzt wird.

In der Figur 3 ist ein zweites Ausführungsbeispiel für die Schalteinrichtung 80 gemäß Figur 1 dargestellt. Im Unterschied zu dem ersten Ausführungsbeispiel gemäß Figur 2 weist die Schalteinrichtung 80 nur einen einzigen Lasertreiber 140 auf. Dieser Lasertreiber 140 steht ausgangsseitig mit drei Schaltern 200, 210 und 220 in Verbindung. Die Schalter 200, 210 und 220 können beispielsweise durch CMOS-Schalter gebildet sein.

Die drei Schalter 200, 210 und 220 werden unmittelbar durch die Steuersignale S1, S2 und S3 aktiviert, die von dem Kontroll-Baustein 70 über die Steuerleitungen ST1, ST2 und ST3 übertragen werden. Die drei Schalter 200, 210 und 220 schalten somit die ihnen individuell zugeordneten Sendeelemente 40, 50 oder 60 entweder ein oder aus.

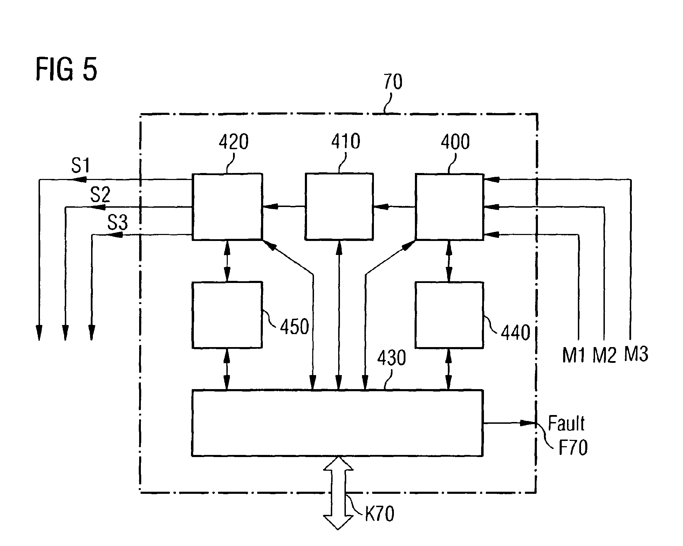

In der Figur 5 ist ein Ausführungsbeispiel für den Kontroll-Baustein 70 gemäß Figure 1 dargestellt. Man erkennt, dass der Kontroll-Baustein 70 eingangsseitig einen Auswahlbaustein 400 enthält, der mit der Monitoreinrichtung 20 in Verbindung steht.

Der Kontroll-Baustein 70 weist darüber hinaus einen dem Auswahlbaustein 400 nachgeordneten Regler 410 auf, der das Messsignal M1, M2 bzw. M3 der Monitoreinrichtung 20 auswertet und entsprechend den Betriebsstrom für das jeweils aktiv geschaltete Sendeelement 40, 50 oder 60 einstellt.

Dem Regler 410 nachgeschaltet ist ein zweiter Auswahlbaustein 420, der den vom Regler 410 erzeugten Betriebsstrom als Steuersignal S1, S2 bzw. S3 über die jeweils zugeordnete Steuerleitung ST1, ST2 bzw. ST3 zu dem ausgewählten Sendeelement 40, 50 bzw. 60 übermittelt. Der erste Auswahlbaustein 400, der Regler 410 sowie der zweite Auswahlbaustein 420 werden von einem Ablaufsteuerungsbaustein 430 angesteuert, bei dem es sich beispielsweise um einen programmierbaren Mikroprozessor handeln kann.

Der Ablaufsteuerungsbaustein 430 ist mit dem Kommunikationsinterface K70 des Kontrollbausteins 70 verbunden. Darüber hinaus steht der Ablaufsteuerungsbaustein 430 mit einer Fehlersignalausgangsschnittstelle F70 des Kontroll-Bausteins 70 in Verbindung. Über diese Fehlersignalausgangsschnittstelle F70 lassen sich Fehlersignale aus dem Ablaufsteuerungsbaustein 430 und damit aus dem Kontroll-Baustein 70 auslesen.

In der Figur 5 erkennt man außerdem einen Schwellwertschalter, der einerseits mit dem Ablaufsteuerungsbaustein 430 und andererseits mit dem Auswahlbaustein 400 in Verbindung steht. Der Schwellwertschalter 440 wertet die Messsignale M1, M2 und M3 der Monitoreinrichtung 20 aus und erzeugt ein entsprechendes Warnsignal W für den Ablaufsteuerungsbaustein 430, wenn der am Auswahlbaustein 400 anliegende Messwert der Monitoreinrichtung 20 einen vorgegebenen Schwellwert unterschreitet. Ein Unterschreiten des im Schwellwertschalter 440 vorgegebenen Schwellwertes deutet darauf hin, dass das jeweils aktive Sendeelement 40, 50 oder 60 defekt ist und durch ein anderes Sendeelement ersetzt werden muss.

Bei Vorliegen des Warnsignals W steuert der Ablaufsteuerungsbaustein 430 den Regler 410 und den zweiten Auswahlbaustein 420 derart an, dass ein anderes Sendeelement aktiviert wird.

In der Figur 5 erkennt man weiterhin eine Lasersicherheitsschaltung 450, die mit dem Ablaufsteuerungsbaustein 430 und dem zweiten Auswahlbaustein 420 zusammenwirkt. Die Funktion der Lasersicherungsschaltung 450 besteht darin, unerlaubte Zustände zu erkennen und die Sendeelemente abzuschalten, wenn eine Gefahrensituation eingetreten ist.

Vorzugsweise enthält der Kontroll-Baustein 70 zusätzlich einen Speicher, der Daten auch ohne eine Stromversorgung speichern kann, beispielsweise einen EEPROM-Speicherbaustein. In einem solchen Fall kann der Kontroll-Baustein 70 während des Betriebs abspeichern, welche Sendeelemente defekt sind; bei jedem Wiedereinschalten des Sendemoduls nach einer Außerbetriebnahme wird der Auswahlbaustein 430 zunächst den Speicher auslesen um festzustellen, welche der Sendeelemente defekt sind und welche nicht. Die als defekt abgespeicherten Sendeelemente werden dann nicht weiter berücksichtigt.

Weist der Kontroll-Baustein 70 hingegen keinen Speicher auf, in dem defekte Sendeelemente abgespeichert werden können, so wird der Kontroll-Baustein 70 in einer festen Reihenfolge vorgehen und zunächst beispielsweise das Sendeelement 40 aktivieren. Falls es sich dabei um ein defektes Sendeelement handelt, so wird der Kontroll-Baustein 70 Sendeelement für Sendeelement nacheinander prüfen, ob das jeweilige Sendeelement in Ordnung ist oder nicht. Sobald der Kontroll-Baustein 70 auf ein betriebsbereites Sendeelement trifft, wird er dieses für den Sendebetrieb aktivieren.

Der Kontroll-Baustein 70 bzw. der Ablaufsteuerungsbaustein 430 kann in einem Speicher außerdem die Arbeitspunkte der einzelnen Sendeelemente digital speichern. Bei Systemen mit einer Regelschleife wird hierzu beispielsweise der Lichtleistungs-Sollwert des Lichtsignals gespeichert; bei gesteuerten Systemen mit einer Ansteuertabelle (Look-up-Tabelle) werden die für den jeweiligen Arbeitspunkt nötigen Betriebsströme, gegebenenfalls auch temperaturabhängig, in der "Look up"-Tabelle gespeichert.

Der Kontroll-Baustein 70 gemäß der Figur 5 führt zusammengefasst also folgende Funktionen aus:
- Der Kontroll-Baustein 70 steuert den Einschaltvorgang des Sendemoduls.
- Der Kontroll-Baustein 70 erkennt defekte bzw. ausgefallene Sendeelemente im Rahmen der Auswertung der eingangsseitig von der Monitoreinrichtung 20 gelieferten Messsignale.
- Der Kontroll-Baustein 70 schaltet die Sendeelemente um, wenn das jeweils aktive Sendeelement ausgefallen oder defekt ist.
- Der Kontroll-Baustein 70 regelt und steuert die Betriebsströme der Sendeelemente.
- Der Kontroll-Baustein 70 speichert die Arbeitspunkte der Sendeelemente.
- Der Kontroll-Baustein speichert die Betriebszustände der Sendeelemente. Dies bedeutet, dass defekte bzw. verbrauchte Sendeelemente gespeichert werden, so dass diese zukünftig nicht mehr eingeschaltet werden.
- Der Kontroll-Baustein 70 gibt an der Fehlersignalausgangsschnittstelle F70 ein Fehlersignal ab, das alle verbrauchten bzw. defekten Laser angibt.
- Der Kontroll-Baustein 70 ist über das Kommunikationsinterface K70 derart programmierbar, dass die Sendeelemente sowohl untereinander als auch mit Sendeelementen anderer Sendemodule abgleichbar sind.
- Der Kontroll-Baustein 70 realisiert eine Ablaufsteuerung zum Abgleich und zur Programmierung von Lasertreibern, die in der nachgeordneten Schalteinrichtung 80 enthalten sind.
- Der Kontroll-Baustein 70 deaktiviert alle Sendeelemente, wenn die Lasersicherheitsschaltung 450 eine Gefahrensituation erkennt.

Der Vollständigkeit halber sei erwähnt, dass der Auswahlbaustein 400 in dem Kontroll-Baustein 70 weggelassen werden kann, wenn die Monitoreinrichtung 20 lediglich ein einziges Messsignal M zur Steuereinrichtung 10 überträgt (vgl. Fig. 1); denn eine Auswahl verschiedener Messsignale ist in einem solchen Fall nicht erforderlich.

Im Übrigen kann die Temperaturabhängigkeit der Monitoreinrichtung 20 mittels des Kontroll-Bausteins 70 kompensiert werden, wenn deren Temperaturverhalten in dem Kontroll-Baustein 70 bekannt bzw. abgespeichert ist.

### Bezugszeichenliste

- 10: Steuereinrichtung
- 20: Monitoreinrichtung
- 30: Monitorelement
- 40: Sendeelement
- 50: Sendeelement
- 60: Sendeelement
- 70: Kontroll-Baustein
- 80: Schalteinrichtung
- 100: Eingangsverstärker
- 110,120,130,140: Lasertreiber
- 200,210,220: Schalter
- 300,310,320: Monitorelemente
- 400: Auswahlbaustein
- 410: Regler
- 420: Zweiter Auswahlbaustein
- 430: Ablaufsteuerungsbaustein
- 440: Schwellwertschalter
- 450: Lasersicherheitsschaltung
- ST1, ST2, ST3: Steuerleitung
- L1, L2, L3: Ansteuerleitung
- M: Messsignal
- m: Messstrom
- S1, S2, S3: Steuersignal

## Patentansprüche

1. Redundantes optisches Sendemodul mit
- zumindest zwei Sendeelementen (40, 50, 60),
- einer mit den zumindest zwei Sendeelementen (40, 50, 60) in Verbindung stehenden Steuereinrichtung (10), die im Sendebetrieb des Sendemoduls jeweils mindestens eines der Sendeelemente (40, 50, 60) aktiv schaltet und zumindest eines der übrigen Sendeelemente (40, 50, 60) passiv schaltet, und
- einer Monitoreinrichtung (20), die die optische Sendeleistung des mindestens einen aktiven Sendeelements (40, 50, 60) misst und ein die jeweilige Sendeleistung angebendes Messsignal (M) an die Steuereinrichtung (10) überträgt,
**dadurch gekennzeichnet, dass**
die Monitoreinrichtung (20) ein Monitorelement (30) aufweist, das mit allen Sendeelementen (40, 50, 60) des Sendemoduls optisch in Verbindung steht.

2. Redundantes optisches Sendemodul nach Anspruch 1, **dadurch gekennzeichnet, dass** die Steuereinrichtung (10) das mindestens eine aktive Sendeelement (40, 50, 60) jeweils abschaltet und durch eines der übrigen zuvor passiven Sendeelemente (40, 50, 60) ersetzt, wenn das mindestens eine aktive Sendeelement (40, 50, 60) defekt ist.

3. Redundantes optisches Sendemodul nach Anspruch 2, **dadurch gekennzeichnet, dass** die Steuereinrichtung 10) das mindestens eine aktive Sendeelement (40, 50, 60) jeweils als defekt ansieht, wenn dieses ein Betriebsverhalten zeigt, das außerhalb eines vorgegebenen Betriebsbereichs liegt.

4. Redundantes optisches Sendemodul nach Anspruch 3, **dadurch gekennzeichnet, dass** der Betriebsbereich sendeelementindividuell vorgegeben ist.

5. Redundantes optisches Sendemodul nach Anspruch 1, **dadurch gekennzeichnet , dass** die Steuereinrichtung (10) das Betriebsverhalten des mindestens einen aktiven Sendeelements (40, 50, 60) jeweils unter Heranziehung des Messsignals (M) der Monitoreinrichtung (20) feststellt.

6. Redundantes optisches Sendemodul nach Anspruch 5, **dadurch gekennzeichnet, dass** die Steuereinrichtung (10) den Betriebsstrom des mindestens einen aktiven Sendeelements (40, 50, 60) steuert und auf eines der übrigen Sendeelemente (40, 50, 60) umschaltet, wenn die optische Sendeleistung des mindestens einen aktiven Sendeelements (40, 50, 60) eine vorgegebene optische Mindestsendeleistung unterschreitet.

7. Redundantes optisches Sendemodul nach Anspruch 6, **dadurch gekennzeichnet, dass** die Steuereinrichtung (10) den Betriebsstrom unter Berücksichtigung vorgegebener Betriebsparameter steuert.

8. Redundantes optisches Sendemodul nach Anspruch 7, **dadurch gekennzeichnet, dass** als Betriebsparameter die Temperatur der Sendeelemente (40, 50, 60) berücksichtigt wird.

9. Redundantes optisches Sendemodul nach Anspruch 1, **dadurch gekennzeichnet, dass** die Steuereinrichtung (10) die Sendeleistung des mindestens einen aktiven Sendeelements (40, 50, 60) durch Nachregeln des Betriebsstromes des mindestens einen aktiven Sendeelements (40, 50, 60) konstant hält und auf eines der übrigen Sendeelemente (40, 50, 60) umschaltet, wenn der zum Erreichen der vorgegebenen optischen Sendeleistung erforderliche Betriebsstrom einen vorgegebenen Maximalstrom überschreitet.

10. Redundantes optisches Sendemodul nach Anspruch 1, **dadurch gekennzeichnet, dass** die Steuereinrichtung (10) einen Speicher aufweist, in dem sie speichert, welche der Sendeelemente (40, 50, 60) defekt sind.

11. Redundantes optisches Sendemodul nach Anspruch 10, **dadurch gekennzeichnet, dass** der Speicher derart ausgestaltet ist, dass er die in ihm gespeicherten Speicherdaten auch während einer Abschaltphase des Sendemoduls (40, 50, 60) gespeichert hält.

12. Redundantes optisches Sendemodul nach Anspruch 11, **dadurch gekennzeichnet, dass** die Steuereinrichtung (10) während des Betriebs des Sendemoduls und nach einem Wiedereinschalten des Sendemoduls lediglich diejenigen Senderelemente (40, 50, 60) für eine Aktivierung in Betracht zieht, die in dem Speicher als nicht defekt abgespeichert sind.

13. Redundantes optisches Sendemodul nach Anspruch 1, **dadurch gekennzeichnet, dass** die Steuereinrichtung (10) einen Kontroll-Baustein (70) und eine mit dem Kontroll-Baustein (70) in Verbindung stehende Schalteinrichtung (80) aufweist, die in Abhängigkeit von Steuersignalen (S1, S2, S3) des Kontroll-Bausteins (70) das jeweils mindestens eine aktive Sendeelement (40, 50, 60) einschaltet.

14. Redundantes optisches Sendemodul nach Anspruch 13, **dadurch gekennzeichnet, dass** die Schalteinrichtung (80) für jedes Sendeelement (40, 50, 60) jeweils eine Treiberschaltung (110, 120, 130) aufweist, die mittels der Steuersignale (S1, S2, S3) des Kontroll-Bausteins (70) aktivierbar oder abschaltbar ist.

15. Redundantes optisches Sendemodul nach Anspruch 13, **dadurch gekennzeichnet, dass** die Schalteinrichtung (80) zumindest eine Treiberschaltung (140) aufweist, die ausgangsseitig zumindest zwei Sendeelementen (40, 50, 60) zugeordnet ist, wobei zwischen der Treiberschaltung (140) und den zugeordneten Sendeelementen (40, 50, 60) jeweils ein Schalter (200, 210, 220) angeordnet ist, der mittels eines Steuersignals (S1, S2, S3) des Kontroll-Bausteins (70) ein- bzw. ausgeschaltet wird.

16. Redundantes optisches Sendemodul nach Anspruch 1, **dadurch gekennzeichnet, dass** die Steuereinrichtung (10) eine Lasersicherheitsschaltung (450) zum Erkennen von unerlaubten Zuständen aufweist, mit der die Sendeelemente (40, 50, 60) im Falle eines unerlaubten Zustandes deaktiviert werden.

17. Redundantes optisches Sendemodul nach Anspruch 1, **dadurch gekennzeichnet, dass** die Steuereinrichtung (10) eine Fehlersignalausgangsschnittstelle (F70) aufweist, mit der Fehlersignale an ein mit dem Sendemodul in Verbindung stehendes externes System übertragbar ist.

18. Redundantes optisches Sendemodul nach Anspruch 1, **dadurch gekennzeichnet, dass** die Steuereinrichtung (10) ein Kommunikationsinterface (K70) aufweist, über das das Sendemodul mit anderen Sendemodulen abgleichbar ist.

19. Verfahren zum Betrieb eines redundanten optischen Sendemoduls mit zumindest zwei Sendeelementen (40, 50, 60), bei dem im Sendebetrieb des Sendemoduls jeweils mindestens eines der Sendeelemente (40, 50, 60) aktiv geschaltet und zumindest eines der übrigen Sendeelemente (40, 50, 60) passiv geschaltet wird und eine Monitoreinrichtung (20)des Sendemoduls die optische Sendeleistung des mindestens einen aktiven Sendeelements (40, 50, 60) misst und ein die jeweilige Sendeleistung angebendes Messsignal (M) an die Steuereinrichtung (10) überträgt, wobei die Monitoreinrichtung (20) ein Monitorelement (30) aufweist, das mit allen Sendeelementen (40, 50, 60) des Sendemoduls optisch in Verbindung steht.

20. Verfahren nach Anspruch 19, **dadurch gekennzeichnet, dass** das mindestens eine aktive Sendeelement (40, 50, 60) abgeschaltet und durch eines der übrigen zuvor passiven Sendeelemente (40, 50, 60) ersetzt wird, wenn das mindestens eine aktive Sendeelement (40, 50, 60) defekt ist.

21. Verfahren nach Anspruch 20, **dadurch gekennzeichnet, dass** das mindestens eine aktive Sendeelement (40, 50, 60) als defekt angesehen wird, wenn dieses ein Betriebsverhalten zeigt, das außerhalb eines vorgegebenen Betriebsbereichs liegt.

## Claims

1. Redundant optical transmitter module with
- at least two transmitter elements (40, 50, 60),
- a control device (10) connected with the at least two transmitter elements (40, 50, 60), which, in transmission mode of the transmitter module, respectively activates at least one of the transmitter elements (40, 50, 60) and deactivates at least one of the remaining transmitter elements (40, 50, 60) and,
- a monitoring device (20) which measures the optical transmission power of the at least one active transmitter element (40, 50, 60) and transmits a measuring signal (M) indicating the respective transmission power to the control device (10),
**characterized in that**
the monitoring device (20) comprises a monitoring element (30) which is optically connected with all transmitter elements (40, 50, 60) of the transmitter module.

2. The redundant optical transmitter module according to Claim 1, **characterized in that** the control device (10) switches off and replaces the at least one active transmitter element (40, 50, 60) through one of the remaining previously passive transmitter elements (40, 50, 60) if the at least one active transmitter element (40, 50, 60) is defective.

3. The redundant optical transmitter module according to Claim 2, **characterized in that** the control device (10) in each case considers the at least one active transmitter element (40, 50, 60) as being defective if said transmitter element exhibits operating characteristics which are outside a predetermined operating range.

4. The redundant optical transmitter module according to Claim 3, **characterized in that** the operating range is predetermined for each individual transmitter element.

5. The redundant optical transmitter module according to Claim 1, **characterized in that** the control device (10) determines the operating characteristics of the at least one active transmitter element (40, 50, 60) each time utilizing the measuring signal (M) of the monitoring device (20).

6. The redundant optical transmitter module according to Claim 5, **characterized in that** the control device (10) controls and switches the operating current of the at least one active transmitter element (40, 50, 60) over to one of the remaining transmitter elements (40, 50, 60) if the optical transmission power of the at least one active transmitter element (40, 50, 60) falls below a predetermined optical minimum transmission power.

7. The redundant optical transmitter module according to Claim 6, **characterized in that** the control device (10) controls the operating current taking into account predetermined operating parameters.

8. The redundant optical transmitter module according to Claim 7, **characterized in that** the temperature of the transmitter elements (40, 50, 60) is taken into account as operating parameter.

9. The redundant optical transmitter module according to Claim 1, **characterized in that** the control device (10) keeps constant and changes the transmission power of the at least one active transmitter element (40, 50, 60) over to one of the remaining transmitter elements (40, 50, 60) through readjusting the operating current if the operating current required for reaching the predetermined optical transmission power exceeds a predetermined maximum current.

10. The redundant optical transmitter module according to Claim 1, **characterized in that** the control device (10) has a memory in which it stores the transmitter elements (40, 50, 60) that are defective.

11. The redundant optical transmitter module according to Claim 10, **characterized in that** the memory is designed in such a manner that it keeps the stored data within it stored even during a switched-off phase of the transmitter module (40, 50, 60).

12. The redundant optical transmitter module according to Claim 11, **characterized in that** the control device (10) during the operation of the transmitter module and after the transmitter module has been switched on again merely considers those transmitter elements (40, 50, 60) for activation which are stored in the memory as being not defective.

13. The redundant optical transmitter module according to Claim 1, **characterized in that** the control device (10) comprises a control module (70) and a switching device (80) connected with the control module (70) which as a function of control signals (S1, S2, S3) of the control module (70) switches on the respective at least one active transmitter element (40, 50, 60).

14. The redundant optical transmitter module according to Claim 13, **characterized in that** the switching device (80) comprises a driver circuit (110, 120, 130) for each transmitter element (40, 50, 60), which driver circuit can be activated or switched off by the control signals (S1, S2, S3) of the control module (70).

15. The redundant optical transmitter module according to Claim 13, **characterized in that** the switching device (80) comprises at least one driver circuit (140) which on the output side is associated with at least two transmitter elements (40, 50, 60), wherein between the driver circuit (140) and the associated transmitter elements (40, 50, 60) a respective switch (200, 210, 220) is arranged which is switched on and switched off by a control signal (S1, S2, S3) of the control module (70).

16. The redundant optical transmitter module according to Claim 1, **characterized in that** the control device (10) comprises a laser safety circuit (450) for detecting impermissible states by which the transmitter elements (40, 50, 60) are deactivated in the event of an impermissible state.

17. The redundant optical transmitter module according to Claim 1, **characterized in that** the control device (10) comprises a fault signal output interface (F70) by which the fault signals can be transmitted to an external system connected with the transmitter module.

18. The redundant optical transmitter module according to Claim 1, **characterized in that** the control device (10) comprises a communication interface (K70) via which the transmitter module can be adjusted to other transmitter modules.

19. A method for operating a redundant optical transmitter module with at least two transmitter elements (40, 50, 60), wherein in transmission mode of the transmitter module at least a respective one of the transmitter elements (40, 50, 60) is activated and at least one of the remaining transmitter elements (40, 50, 60) is deactivated and a monitoring device (20) of the transmitter module measures the optical transmission power of the at least one active transmitter element (40, 50, 60) and transmits a measuring signal (M) indicating the respective transmission power to the control device (10), wherein the monitoring device (20) comprises a monitoring element (30) which is optically connected with all transmitter elements (40, 50, 60) of the transmitter module.

20. The method according to Claim 19, **characterized in that** the at least one active transmitter element (40, 50, 60) is switched off and replaced through one of the remaining previously passive transmitter elements (40, 50, 60) if the at least one active transmitter element (40, 50, 60) is defective.

21. The method according to Claim 20, **characterized in that** the at least one active transmitter element (40, 50, 60) is considered as being defective if said transmitter element exhibits operating characteristics which are outside a predetermined operating range.

## Revendications

1. Module d'émission optique redondante avec
- au moins deux éléments (40, 50, 60) d'émission,
- un dispositif (10) de commande se trouvant en liaison avec au moins les deux éléments (40, 50, 60) d'émission et qui, en mode d'émission du module d'émission, met respectivement au moins un des éléments (40, 50, 60) d'émission en commutation active et au moins un des autres éléments (40, 50, 60) d'émission en commutation passive, et
- un dispositif (20) de supervision, qui mesure la puissance d'émission optique d'au moins l'élément (40, 50, 60) d'émission actif et transmet un signal (M) de mesure indiquant la puissance d'émission respective au dispositif (10) de commande,
**caractérisé en ce que** le dispositif (20) de supervision présente un élément (30) de supervision qui se trouve optiquement en liaison avec tous les éléments (40, 50, 60) d'émission du module d'émission.

2. Module d'émission optique redondante selon la revendication 1, **caractérisé en ce que** le dispositif (10) de commande arrête à chaque fois au moins l'élément (40, 50, 60) d'émission actif et le remplace par un des autres éléments (40, 50, 60) d'émission auparavant passifs lorsque au moins l'élément (40, 40, 60) d'émission actif est défaillant.

3. Module d'émission optique redondante selon la revendication 2, **caractérisé en ce que** le dispositif (10) de commande juge respectivement au moins l'élément (40, 50, 60) d'émission actif défaillant lorsque celui-ci montre une tenue en service qui se situe en dehors d'un domaine de fonctionnement prédéfini.

4. Module d'émission optique redondante selon la revendication 3, **caractérisé en ce que** le domaine de fonctionnement prédéfini est propre à chaque élément d'émission.

5. Module d'émission optique redondante selon la revendication 1, **caractérisé en ce que** le dispositif (10) de commande fixe respectivement la tenue en service d'au moins l'élément (40, 50, 60) d'émission actif en se servant du signal (M) de mesure du dispositif (20) de supervision.

6. Module d'émission optique redondante selon la revendication 5, **caractérisé en ce que** le dispositif (10) de commande régit le courant de service d'au moins l'élément (40, 50, 60) d'émission actif et bascule vers l'un des autres éléments (40, 50, 60) lorsque la puissance d'émission optique d'au moins l'élément (40, 50, 60) d'émission actif n'atteint pas une puissance d'émission optique prédéfinie.

7. Module d'émission optique redondante selon la revendication 6, **caractérisé en ce que** le dispositif (10) de commande régit le courant de service en tenant compte de paramètres de service prédéfinis.

8. Module d'émission optique redondante selon la revendication 7, **caractérisé en ce que** la température des éléments (40, 50, 60) est prise en compte en tant que paramètre de service.

9. Module d'émission optique redondante selon la revendication 1, **caractérisé en ce que** le dispositif (10) de commande maintient constante la puissance de service d'au moins l'élément (40, 50, 60) d'émission actif en rectifiant le courant de service d'au moins l'élément (40, 50, 60) d'émission actif et bascule vers l'un des autres éléments (40, 50, 60) d'émission lorsque le courant de service nécessaire à l'obtention de la puissance de service optique prédéfinie dépasse un courant maximum prédéfini.

10. Module d'émission optique redondante selon la revendication 1, **caractérisé en ce que** le dispositif (10) de commande présente une mémoire dans laquelle il mémorise ceux des éléments (40, 50, 60) qui sont défaillants.

11. Module d'émission optique redondante selon la revendication 10, **caractérisé en ce que** la mémoire est configurée de telle sorte qu'elle conserve les données de mémoire qui sont mémorisées en elle, même pendant une phase d'arrêt du module (40, 50, 60) d'émission.

12. Module d'émission optique redondante selon la revendication 11, **caractérisé en ce que** le dispositif (10) de commande n'envisage d'activer pendant le service du module d'émission et après une remise en marche du module d'émission que ceux des éléments (40, 50, 60) d'émission qui sont mémorisés comme non défaillants dans la mémoire.

13. Module d'émission optique redondante selon la revendication 1, **caractérisé en ce que** le dispositif (10) de commande présente un bloc (70) de contrôle et un dispositif (80) de déclenchement se trouvant en liaison avec le bloc (70) de contrôle qui, en fonction de signaux (S1, S2, S3) de commande du bloc (70) de contrôle, déclenche au moins l'élément (40, 50, 60) d'émission actif.

14. Module d'émission optique redondante selon la revendication 13, **caractérisé en ce que** le dispositif (80) de déclenchement présente pour chaque élément (40, 50, 60) un circuit (110, 120, 130) d'attaque respectif qui peut être activé ou arrêté au moyen des signaux (21, S2, S3) de commande du bloc (70) de contrôle.

15. Module d'émission optique redondante selon la revendication 13, **caractérisé en ce que** le dispositif (80) de déclenchement présente au moins un circuit (140) d'attaque, à la sortie duquel sont affectés au moins deux éléments (40, 50, 60) d'émission, un interrupteur (200, 210, 220) étant respectivement agencé entre le circuit (140) d'attaque et les éléments (40, 50, 60) d'émission affectés, lequel est mis en marche ou à l'arrêt au moyen d'un signal (S1, S2, S3) de commande du bloc (70) de contrôle.

16. Module d'émission optique redondante selon la revendication 1, **caractérisé en ce que** le dispositif (10) de commande présente un circuit (450) de sécurité à laser pour identifier des états non autorisés, avec lequel les éléments (40, 50, 60) d'émission sont désactivés dans le cas d'un état non autorisé.

17. Module d'émission optique redondante selon la revendication 1, **caractérisé en ce que** le dispositif (10) de commande présente une interface (F70) de sortie de signal de défaut, avec lequel des signaux de défaut peuvent être transmis à un système externe se trouvant en liaison avec le module d'émission.

18. Module d'émission optique redondante selon la revendication 1, **caractérisé en ce que** le dispositif (10) de commande présente une interface (K70) de communication, via laquelle le module d'émission peut être accordé avec d'autres modules d'émission.

19. Procédé pour exploiter un module d'émission optique redondante avec au moins deux éléments (40, 50, 60) d'émission, dans lequel pendant le mode d'émission du module, au moins un des éléments (40, 50, 60) d'émission est mis en commutation active et au moins un des autres éléments (40, 50, 60) d'émission est mis en commutation passive, et un dispositif (20) de supervision du module d'émission mesure la puissance d'émission optique d'au moins l'élément (40, 50, 60) d'émission actif et transmet un signal (M) de mesure indiquant la puissance d'émission respective au dispositif (10) de commande, le dispositif (20) de supervision présentant un élément (30) de supervision qui se trouve optiquement en liaison avec tous les éléments (40, 50, 60) du module d'émission.

20. Procédé selon la revendication 19, **caractérisé en ce qu'**au moins l'élément (30, 40, 60) d'émission actif est arrêté et remplacé par l'un des autres éléments (40, 50, 60) d'émission auparavant passifs, lorsqu'au moins l'élément (40, 50, 60) d'émission actif est défaillant.

21. Procédé selon la revendication 20, **caractérisé en ce qu'**au moins l'élément (40, 50, 60) d'émission actif est considéré comme défaillant lorsque celui-ci montre une tenue en service qui se situe en dehors d'un domaine de fonctionnement prédéfini.
